(19)

Europäisches
Patentamt

European
Patent Office

Office européen
des brevets

(11) **EP 3 828 890 A1**

(12) **EUROPEAN PATENT APPLICATION**

(43) Date of publication:
02.06.2021 Bulletin 2021/22

(21) Application number: 19383048.6

(22) Date of filing: 26.11.2019

(51) Int Cl.:
*G11C 11/16* *(2006.01)*  *G11B 5/65* *(2006.01)*
*H01F 10/00* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **Consejo Superior de Investigaciones Científicas**
**(CSIC)**
**28006 Madrid (ES)**

(72) Inventors:
• **FINA MARTÍNEZ, Ignasi**
 **08193 Cerdanyola del Vallès (Barcelona) (ES)**
• **FONTCUBERTA GRIÑO, Josep**
 **08193 Cerdanyola del Vallès (Barcelona) (ES)**
• **SÁNCHEZ BARRERA, Florencio**
 **08193 Cerdanyola del Vallès (Barcelona) (ES)**

(74) Representative: **Pons**
 **Glorieta Ruben Dario 4**
 **28010 Madrid (ES)**

(54) **AN ANTIFERROMAGNETIC BENDABLE RECORDING DEVICE**

(57)    The present invention relates to an antiferromagnetic recording device which comprises a bendable antiferromagnetic alloy memory element, a writing element, a heating element and an electrical reading element. Therefore, the present invention could be included in the field of spintronics, referring to magnetic materials and devices.

EP 3 828 890 A1

**Description**

The present invention relates to an antiferromagnetic recording device which comprises a bendable antiferromagnetic alloy memory element, a writing element, a heating element and an electrical reading element. Therefore, the present invention could be included in the field of spintronics, referring to magnetic materials and devices.

**BACKGROUND ART**

Development of functional material on flexible substrates is a fast growing activity due to enormous potential for applications as technology moves towards mobile and wearable. Apart from the expected bust of flexible displays targeting the huge market of cell phones, with more than 5 billion units being used worldwide during 2017, electronic components on flexible substrates have already been receiving attention in many other high-tech areas [D.H. Kim et al., Adv. Mater. 20, 4887 (2008); S. Wagner et al., MRS Bull. 37, 207 (2012)]. So far, electronic and sensing functions have received the highest attention. Referring to magnetic sensing, giant magnetoresistance and magnetoimpedance devices are probably ahead [I. Mönch et al., ACS Nano 5, 7436 (2011); M. Melzer et al., RSC Adv. 2, 2284 (2012); T. Vemulkar et al., Adv. Funct. Mater. 26, 4704 (2016)].

Magnetic materials and devices have been engineered on polymeric substrates. For instance, embedded ferromagnetic elements [M. Donolato et al., Adv. Mater. 25, 623 (2013)], anisotropic magnetoresistive [M. Melzer et al., Adv. Mater. 27, 1274 (2015)], GMR [M. Melzer et al., Nat. Commun. 6, 6080 (2015)] and Hall effect sensors [Z. Wang et al., Adv. Mater. 28, 9370 (2016)], synthetic antiferromagnets (SAF) [T. Vemulkar et al., Adv. Funct. Mater. 26, 4704 (2016)], magnetic tunneling devices [J.-Y. Chen et al., Sci. Rep. 7, 42001 (2017)]. In most of the cases, non-ordered (amorphous or polycrystalline) magnetic metallic alloys were used because they allow for a close-to-room-temperature growth as required by the compatibility with polymers, which prevents to obtain metallic magnets with high crystalline quality. In contrast, the design of devices exploiting the rich functional properties of crystalline materials, including oxides, has been limited by the relatively high temperature (typically 400-800 °C) needed to grow crystalline materials, including metals and perovskite or spinel oxides, and the scarcity of high-temperature processable flexible substrates. Recent success using the high-temperature melting and flexible muscovite mica as a substrate has permitted the growth of crystalline ferromagnetic and ferroelectric oxides, thus opening new perspectives [J. Liu, Y. Feng, R. Tang, R. Zhao, J. Gao, D. Shi, H. Yang, Adv. Electron. Mater. 2018, 4, 1700522].

Other than sensing, magnetic materials are well known for their importance as data storage media and magnetic metals are nowadays major players in hard disks and are constitutive of the magnetic random access memory elements (MRAMs), all of them using unbendable substrate. In spite of the success of ferromagnetic metals in MRAMs, limitations exist related to energy efficient magnetization switching and integration. Indeed, inherent to ferromagnetic materials is the existence of magnetic stray fields that may induce crosstalk with neighboring memory cells and, thus, destabilizing the system from a magnetic viewpoint. Spintronics is now turning the focus towards antiferromagnets because, due to the absence of stray fields, they could provide radically new solutions for data storage, particularly in some niche applications [V. Baltz, A. Manchon, M. Tsoi, T. Moriyama, T. Ono, Y. Tserkovnyak, Rev. Mod. Phys. 2018, 90, 015005].

Therefore, it is opportunity to develop new crystalline antiferromagnetic and bendable devices for data storage.

**DESCRIPTION OF THE INVENTION**

The present invention relates to an antiferromagnetic recording device which comprises a bendable antiferromagnetic alloy memory element, a writing element, a heating element and an electrical reading element. The antiferromagnetic recording device of the present invention is bendable and displays an antiferromagnetic to ferromagnetic transition upon changing temperature, and magnetic properties are kept virtually unaltered upon repeated tests, exhibiting robustness and endurance. After a suitable data writing process in the high temperature ferromagnetic (FM) state, and cooled to the operation temperature, the antiferromagnetic recording device is used to store magnetic information in its antiferromagnetic (AFM) state. The magnetic information written in the ferromagnetic (FM) state of the antiferromagnetic recording device remains frozen and it is cloaked in the AFM state. In the AFM state two magnetic textures (perpendicular between them) are stabilized by the writing process. Thus, state A is first antiferromagnetic parallel state and state B is second antiferromagnetic perpendicular state.

**DETAILED DESCRIPTION OF THE INVENTION**

The first aspect of the present invention refers to an antiferromagnetic recording device (herein "the device of the present invention") characterized in that it comprises

- a bendable antiferromagnetic alloy memory element having a first antiferromagnetic parallel state A and a second antiferromagnetic perpendicular state B, said bendable magnetic memory element, configured to store information in its parallel A and perpendicular B states,

- a writing element configured to set the magnetization direction of the bendable magnetic memory element to its antiferromagnetic parallel A and perpendicular B states,
- a heating element having a first on state and a second off state, said heating element configured to set the bendable magnetic memory element from its antiferromagnetic to its ferromagnetic phases,
- and an electrical reading element configured to measure the electrical resistance of the bendable antiferromagnetic alloy memory element.

The "bendable antiferromagnetic alloy memory element" of the antiferromagnetic recording device of the present invention has a first antiferromagnetic parallel state and a second antiferromagnetic perpendicular state. Said bendable magnetic memory element configured to store information in its parallel A and perpendicular states B. The bendable antiferromagnetic alloy memory element of the present invention exhibits a complete antiferromagnetic to ferromagnetic phase transition while heating.

The term "writing element" of the antiferromagnetic recording device of the present invention refers herein to an element configured to set the magnetization direction of the bendable magnetic memory element in the ferromagnetic phase along perpendicular directions at high temperature of between -200°C and 800°C. When cooled the magnetic state is "frozen" in the antiferromagnetic state. Thus, two states A and B can be written in the antiferromagnetic state being them perpendicular. The writing element allows creating

- a magnetic field by a magnet or electrical currents or an electromagnet
- or a magnetic spin transfer torque

in the bendable antiferromagnetic alloy memory element thereby setting the direction of its magnetization along perpendicular directions at high temperature of between -200 °C and 800°C at the ferromagnetic state.

The "heating element" of the antiferromagnetic recording device of the present invention has a first on state and a second off state. Said heating element is configured to set the bendable magnetic memory element from its antiferromagnetic phase to its ferromagnetic phase and vice versa. When the heating element is in its off state, the bendable antiferromagnetic alloy memory element is in its antiferromagnetic state, thus at the working temperature of between -200 °C and 800 °C.

The "electrical reading element" of the antiferromagnetic recording device of the present invention refers herein to an element which is configured to measure the electrical resistance of the memory element. The electrical resistance of the antiferromagnetic recording device is different depending on the relative direction between the electrical current and the antiferromagnetic axis, corresponding to first antiferromagnetic parallel (state A) and to the second antiferromagnetic perpendicular (state B) states. Changing the direction of the antiferromagnetic axis, by using the writing protocol described above, different states A and B are written. The different states A and B are detected by reading the resistance. The reading procedure is nondestructive. The antiferromagnetic axis, that is its direction, is not modified during the reading protocol.

In a preferred embodiment of the antiferromagnetic recording device of the present invention, the bendable antiferromagnetic alloy memory element comprises a layer of a crystalline metallic alloy of formula

$$TM_{1-x}HM_x,$$

wherein TM refers to transition metal selected from Fe, Mn, Co and Ni.

HM are heavy metals selected from Rh, Pt and Pd, and x ranges from 0 to 1.

More preferably, the layer of the crystalline metallic alloy is of $\alpha$-FeRh.

In a preferred embodiment of the device of the invention, the layer of the crystalline metallic alloy of the bendable antiferromagnetic alloy memory element has a thickness of between 50 nm and 150 nm.

In a preferred embodiment of the device of the invention, the bendable antiferromagnetic alloy memory element further comprises

- a substrate of a flexible metallic material,
- a capping electrical insulating layer located onto the substrate,
- and wherein the layer of the crystalline metallic alloy is located onto the capping electrical insulating layer.

In a preferred embodiment of the device of the invention, the bendable antiferromagnetic alloy memory element further comprises a protective layer located onto the layer of the crystalline metallic alloy. More preferably, the protective layer has a thickness of between 10 nm and 20 nm.

In another preferred embodiment of the device of the invention, the bendable antiferromagnetic alloy memory element comprises

○ a substrate of a flexible Nickel-Molybdenum-Chromium alloy
○ a capping electrical insulating layer of a columnar MgO carpet;
○ a layer of a crystalline metallic alloy of $\alpha$-FeRh; and
○ a Pt protecting layer.

Results show that the magnetic properties of the $\alpha$-FeRh films grown on this substrate, rival those of $\alpha$-FeRh films grown on single crystalline unbendable substrates, also showing a sharp AFM to FM phase transition between 50 °C and 150 °C. Moreover, said $\alpha$-FeRh films can be reversibly bended at least to strains of about 0.02 % without bend-induced cracking.

In a preferred embodiment of the device of the invention, the writing element is configured to create a magnetic field for setting the magnetization direction of the bendable magnetic memory element with permanent magnetic element, electrical current or an electromagnet.

In another preferred embodiment of the device of the invention, the writing element is configured to create a spin transfer torque for setting the magnetization direction of the bendable magnetic memory element to its second ferromagnetic state by means of an electric current.

In a preferred embodiment of the device of the invention, the electrical reading element of the present invention preferably comprises at least two electrical contacts. More preferably, the electrical reading element comprises between 2 and 6 electrical contacts: two-terminal, four-terminal or six-terminal contacts.

For instance, in the case where two wires are connected to the device, an electrical current is injected across it and the same wires are used to read the voltage across the device. This reading is proportional to its resistance.

Another example is the case where four wires are used, two of them are used to inject electrical current and two independent ones are used to read the voltage drop across the device. It turns out that this voltage is also proportional to the resistance of the device.

Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention.

## BRIEF DESCRIPTION OF THE DRAWINGS

Figure 1. Schematic of the antiferromagnetic recording device.

Figure 2. (a) Sketch of the flexible $\alpha$-FeRh magnetic film. (b) Sketch of the different crystalline orientation of MgO-Tape. (c) Tilted electron microscopy view of of the flexible $\alpha$-FeRh.

Figure 3. (a) Photographs of a flat (left) and bended (right) 25 by 12 $mm^2$ FeRh-Tape sample. (b) SE images of representative FeRh-Tape region after indicated number of bending cycles up to $r_b$ = 200 mm. (c) SE image of representative FeRh-Tape region after bending it up to $r_b$ = 10 mm.

Figure 4. M(T) cycle collected at 500 Oe from 27 °C to 227 °C to 27 °C following the arrows directions of $\alpha$-FeRh flexible magnetic film. Sharp AFM-FM transition is observed.

Figure 5. M(T) cycle collected at 500 Oe from 27 °C to 227 °C to 27 °C following the arrows directions of a FeRh film grown on top of a single MgO(001) single-crystal. Sharp AFM-FM transition is observed.

Figure 6. $\Theta$-2$\Theta$-scan (integrated intensity along $\Psi$,) of the $\alpha$-FeRh magnetic film

Figure 7. (a) Sketch of the experimental set-up used to bend the FeRh-tape together with the lateral pictures of the FeRh-tape bended up to $r_b \approx$ 1200, 500, and 300 mm. The section of the FeRh-Tape sample located within the black rectangle has been used to calculate the $r_b$. (b) MOKE signal normalized to its value at 185 °C measured at several temperatures on FeRh-Tape with different $r_b$. Solid line corresponds to the data collected by VSM on the unbended FeRh sample.

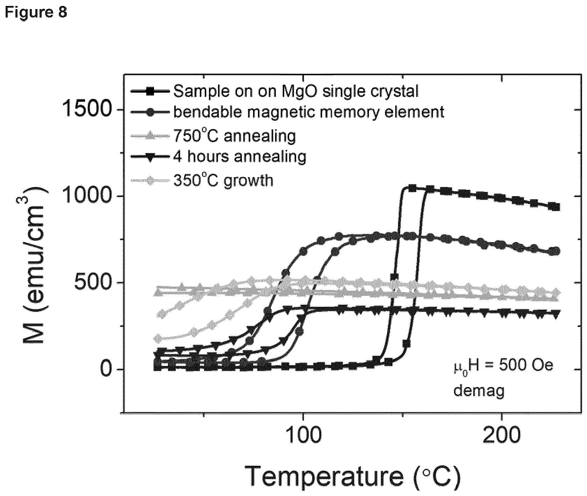

Figure 8. M(T) for $\alpha$-FeRh magnetic film grown in a single crystalline [MgO(001)] substrate, the bendable antiferromagnetic alloy memory element, a FeRh-tape annealed at higher compared to the bendable antiferromagnetic element (750°C) temperature, a FeRh-tape annealed for longer compared to the bendable antiferromagnetic element (4 hours) time, and a $\alpha$-FeRh magnetic film growth at higher compared to the bendable antiferromagnetic element (350°C) temperature. It can be observed that all the variations of the growth conditions of the $\alpha$-FeRh magnetic film sample referred in the main sample do not result in better functional properties, and both the magnetization at high temperature and the transition temperature (between 50 °C and 150 °C) are always smaller.

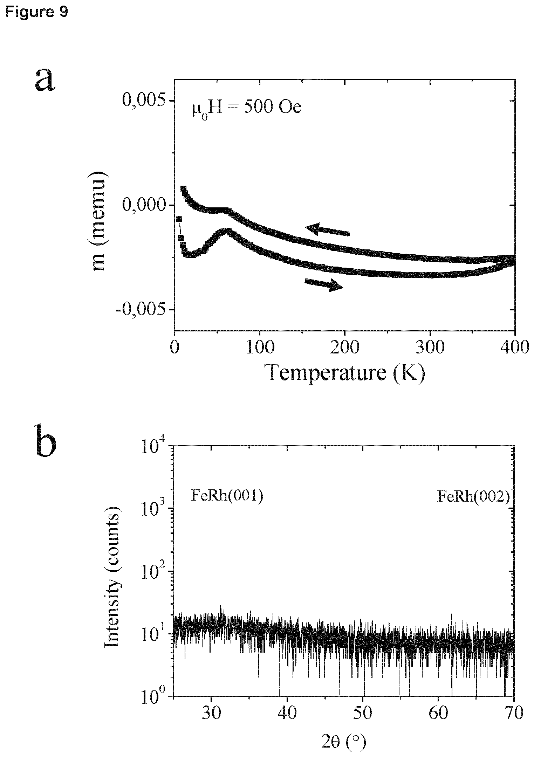

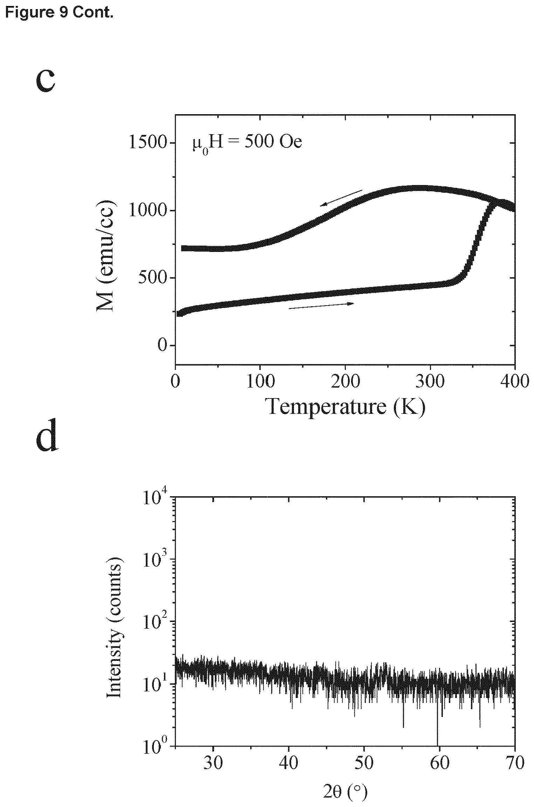

Figure 9. (a) M(T) cycle collected at 500 Oe 27 °C to 227 °C to 27 °C following the arrows directions of $\alpha$-FeRh magnetic film grown on flexible plastic. Sharp AFM-FM transition cannot be observed; (b) $\Theta$-2$\Theta$-scan of the $\alpha$-FeRh magnetic film grown on flexible plastic. Diffraction peaks corresponding to the FeRh crystalline grown can not be observed; (c) M(T) cycle collected at 500 Oe from 27 °C to 227 °C to 27 °C following the arrows directions of $\alpha$-FeRh magnetic film grown on flexible mica moscovita. Sharp AFM-FM transition cannot be observed; (d) $\theta$-2$\theta$-scan of the $\alpha$-FeRh magnetic film grown on flexible mica moscovita. Diffraction peaks corresponding to the FeRh crystalline grown cannot be observed.

## EXAMPLES

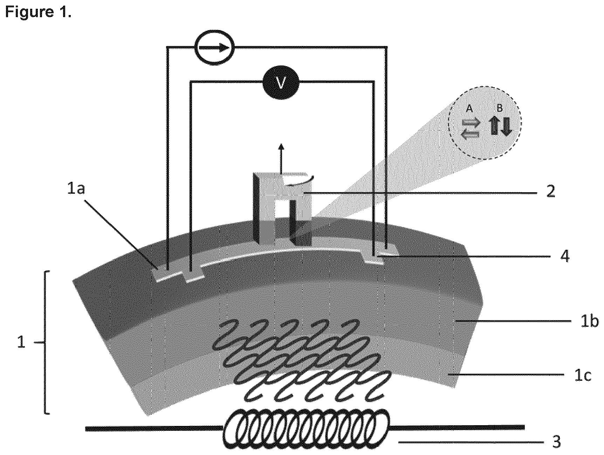

Figure 1 shows a schematic of the antiferromagnetic recording device comprising the following elements:

(1) bendable antiferromagnetic alloy memory element
(1a) layer of a crystalline metallic alloy
(1b) capping electrical insulating layer
(1c) substrate of a flexible metallic material
(2) writing element
(3) heating element
(4) electrical reading element

*Sample growth.* FeRh (57 nm) films (1a) have been grown on a textured MgO buffer ($\approx$ 2 $\mu$m thick) prepared by ISD (Inclined Substrate Deposition) technique on a Nickel-Molybdenum-Chromium alloy (C267 HASTELLOY®) flexible tape (1c) ($\approx$ 100 $\mu$m-thick) (Theva Dünnschichttechnik GmbH). The FeRh layer (1a) has been protected *in-situ* by a 20 nm-Pt coating (as protective coating 1d). The MgO-C267 tape (1b) with 25 mm long and 12 mm wide was cut into 10 mm $\times$ 12 mm pieces and fixed into the sample holder of the sputtering chamber by using Ag paste. The tape substrate (1c) was heated up to the deposition temperature $T_D$ = 300° in a base pressure of 0.01 mbar of Ar. The FeRh film (1a) was grown by DC magnetron sputtering using 20 W power at a rate of 0.8Å s$^{-1}$ from a stoichiometric target. Afterwards the film was annealed at $T_A$ = 700°C in a pressure of 0.1 mbar of Ar for $t_A$= 1 h and subsequently cooled down to room temperature at a -100°C min$^{-1}$ rate. Finally, at room temperature 20 nm of Pt has been deposited by sputtering in 0.005 mbar of Ar atmosphere using 20 W power. The control sample grown on MgO single crystal (1b) has been grown using the same conditions. Other samples have been also grown on flexible tape using slightly different conditions, as summarized in Table 1.

Table 1. Summary of the characterized samples.

| Sample | $T_D$(°C) | $T_A$(°C) | $t_A$ (hours) |
|---|---|---|---|
| Main sample | 300 | 700 | 1 |
| Different $T_D$ | 350 | 700 | 1 |
| Different $T_A$ | 300 | 750 | 1 |
| Different $t_A$ | 300 | 700 | 4 |
| $T_D$ = deposition temperature<br>$T_A$ = temperature of annealing<br>$t_A$ = time of annealing | | | |

*X-ray characterization.* The crystal structure was analyzed by X-ray diffraction (XRD) using Cu $K_\alpha$ radiation. 2D diffraction $2\theta$-$\Psi$ images along $\theta$-$2\theta$ and $\Psi$ were acquired using Bruker D8 Advance diffractometer with area detector.

*Morphological characterization.* SE and BS SEM images were recorded using a Fei Quanta 200EF microscope. FeRh-SC sample was cleaved and FeRh-Tape sample cutted and imaged with a tilting angle of $\approx 80°$ with respect the normal film direction. Composed (SE+BS) images were the result of the sum of SE and BE images, to better visualize MgO and FeRh contrast.

*Magnetic characterization.* Magnetization versus temperature characteristics were measured by Vibrating Sample Magnetometer platform from Quantum Design at H = 500 Oe, along the in-plane direction.

*Magneto-optic Kerr effect characterization.* The evolution of the local magnetic properties has been investigated using a Durham Magneto Optics Ltd polar magneto-optic Kerr effect (MOKE) apparatus with a laser spot focused down to around 3 $\mu$m.

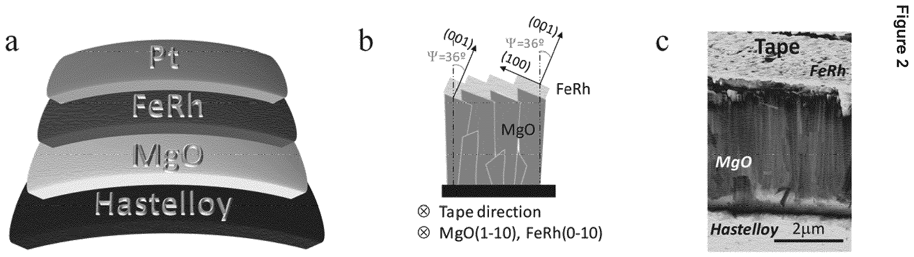

FeRh (57 nm) films are grown by sputtering on a textured MgO buffer ($\approx$ 2 $\mu$m thick) flexible tape (C267 HASTELLOY®) using the conditions defined in the experimental section. The FeRh layer has been in-situ capped with 20 nm-Pt to avoid oxidation. The structure of the sample is sketched in Figure 2a. To be used as a control sample, a FeRh film was also grown on a single crystalline MgO(001) substrate using identical conditions. In the following, these samples are denoted FeRh-Tape (corresponding to the bendable magnetic element) and FeRh-SC, respectively. In the FeRh-Tape sample, the MgO grows forming columns grown tilted with respect to the metallic substrate and therefore the (001)MgO planes are tilted with respect to the sample normal and thus the most intense (00/) reflections of MgO and potentially those of FeRh and Pt (sketch in Figure 2b). In Figure 2c, it can be appreciated that the FeRh-layer of the FeRh-Tape sample has grown with a grainy surface morphology on top of a columnar-like MgO carpet.

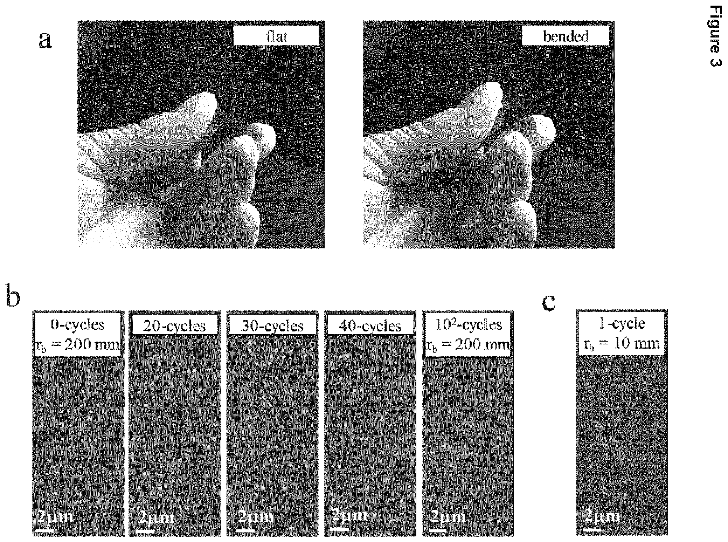

In Figure 3a, a FeRh-Tape 25 mm wide, 12 mm long sample is shown in its unbended and bended states to illustrate its flexibility. In Figure 3b, secondary electrons (SE) scanning electron microscopy (SEM) images of the same sample without being bended is shown after growth (0-cycles) and after indicated cycles up to $r_b$ = 200 mm, where is $r_b$ is the bending radii. In contrast, when the bending radius is reduced $r_b \approx 10$ mm, a rather regular pattern of cracks, spaced by about 2-5 $\mu$m, can be appreciated in the SE image of Figure 3c.

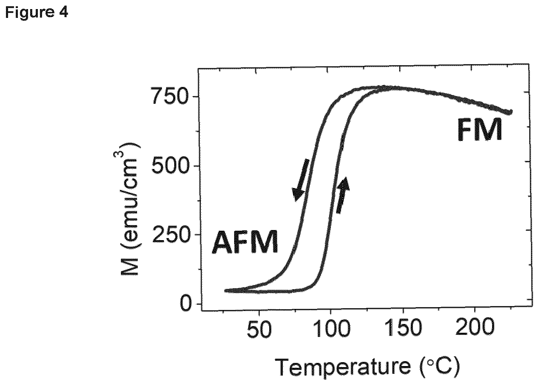

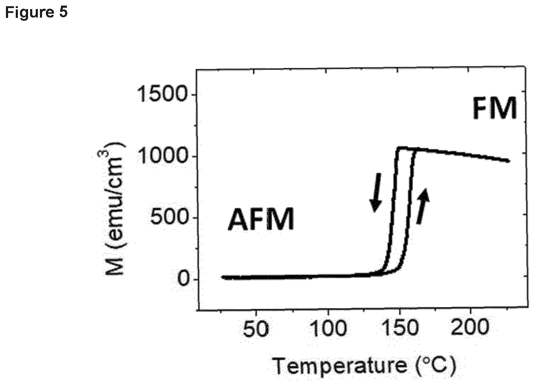

Figure 4 shows the temperature-dependent in-plane magnetization M(T) data of the FeRh-Tape sample, collected using an in-plane magnetic of H = 500 Oe by vibrating sample magnetometer (VSM). Data have been recorded upon cooling and subsequent heating as indicated by the arrows. The M(T) displays a sharp increase of magnetization when increasing the temperature at $T_{N,w} \approx 110$ °C evidencing an AFM to FM phase transition. Upon cooling, the reduction of magnetization (FM to AFM transition) is observed starting at about $T_{N,c} \approx 90$ °C. The hysteretic behavior of M(T) is a fingerprint of the occurrence of first order transition as expected in the AFM to FM phase transition of FeRh. Remarkably, the magnetization value at high temperature and the sharpness of the transition, both being signatures of the film quality, are close to those obtained in FeRh-SC (data in Figure 5).

In the M(T) data of Figure 4, it can also be appreciated that there is a residual magnetization (around 40 emu cm$^{-3}$) at room temperature, where the sample is nominally in the AFM state, indicating the presence of FM residues within the AF phase. In comparison, the residual magnetization is much smaller in the FeRh-SC film (14 emu cm$^{-3}$). Correspondingly, it can also be appreciated in Figure 4 that the increase of magnetization at the AFM-FM transition is slightly reduced in the FeRh-Tape compared to that of the FeRh-SC film (see Figure 5). These differences result from the fact that the stabilization of the $\alpha$-FeRh is critically dependent on the substrate microstructure and growth conditions. It is indeed expected that the microstructure of the FeRh film grown on the MgO-buffered tape is more defective than that of the FeRh-SC. In spite of these minor and probably unavoidable differences, the magnetic data collected on the FeRh-Tape clearly indicate that the desired $\alpha$-FeRh phase has been stabilized on the flexible substrate.

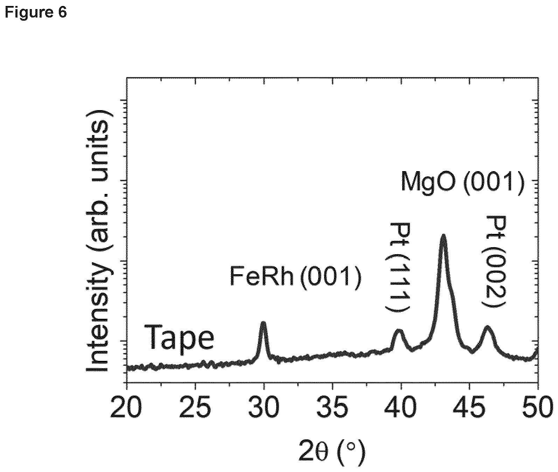

In Figure 6 the $\theta$-$2\theta$ scans is shown; the intensity has been integrated (approx. $\pm 15°$) along $\Psi$. FeRh-Tape shows clear reflections indicate its good crystalline quality.

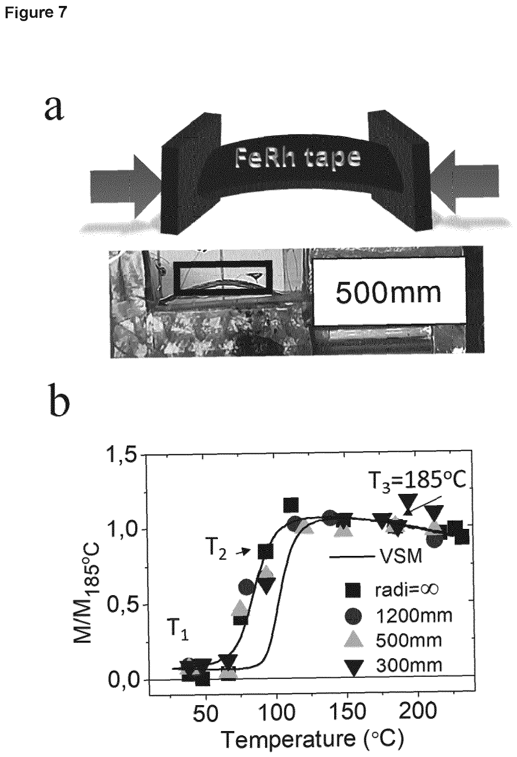

In order to determine the robustness against bending of FeRh-Tape samples longitudinal magneto-optic Kerr effect (MOKE) measurements were recorded by applying an in-plane magnetic field (H < 500 Oe) while subjecting the FeRh-Tape to variable bending stresses (see the experimental set-up in Figure 7a. The tape has been laterally pressed by two aluminum pieces to obtain $r_b \approx 300$ mm, 500 mm, 1200 mm and $\infty$ ($\equiv$ unbended) as shown in Figure 7b.

Using classical elastic theories, the in-plane strain induced on the film of thickness $t$ grown a substrate, by a bending of radius $R$ can be estimated by using

$$\varepsilon = \left( \frac{y + t}{R} \right)$$

where $y$ is the distance from the neutral line of the whole FeRh/MgO/Hastelloy heterostructures. As the thickness of $t$(FeRh) ($\approx$ 50 nm) is much smaller than that of the MgO/Hastelloy substrate ($\approx$102 $\mu$m), then y $\approx$ 102 $\mu$m/2 = 51 $\mu$m)

and thus the substrate imposes a roughly homogenous compressive stress on the FeRh of about $\varepsilon$ = 0.017% for R = 300 mm.

Figure 8 shows the M(T) curves collected for samples grown at slightly different conditions of the main FeRh-tape sample (summarized in Table 1). Important degradation of the AFM-FM transition is observed. Therefore, the window conditions for the grow of this material on flexible substrate is limited.

Figure 9a,c show the M(T) curves for samples grown on alternative flexible substrates: plastic and mica, respectively. In both case sharp AFM-FM transition is absent. In Figure b, d, the corresponding $\theta$-$2\theta$ scans are shown for samples grown on alternative flexible substrates (plastic and mica, respectively). Diffraction peaks are absent, which indicate that films are poorly crystalline or polycrystalline.

**Claims**

1. An antiferromagnetic recording device **characterized in that** it comprises

   • a bendable antiferromagnetic alloy memory element (1) having a first antiferromagnetic parallel state A and a second antiferromagnetic perpendicular state B, said bendable magnetic memory element, configured to store information in its parallel and perpendicular states,
   • a writing element (2) configured to set the magnetization direction of the bendable magnetic memory element to its antiferromagnetic parallel A and perpendicular B states,
   • a heating element (3) having a first on state and a second off state, said heating element configured to set the bendable magnetic memory element from its antiferromagnetic to its ferromagnetic phases,
   • and an electrical reading element (4) configured to measure the electrical resistance of the bendable antiferromagnetic alloy memory element.

2. The antiferromagnetic recording device according to claim 1, wherein the bendable antiferromagnetic alloy memory element (1) comprises a layer of a crystalline metallic alloy (1a) of formula

   $$TM_{1-x}HM_x,$$

   wherein TM refers to transition metal selected from Fe, Mn, Co and Ni.
   HM are heavy metals selected from Rh, Pt and Pd,
   and x ranges from 0 to 1.

3. The antiferromagnetic recording device according to claim 2, wherein the bendable antiferromagnetic alloy memory element (1) comprises $\alpha$-FeRh.

4. The antiferromagnetic recording device according to any of claims 2 or 3, wherein the bendable antiferromagnetic alloy memory element (1) has a thickness of between 50 nm and 150 nm.

5. The antiferromagnetic recording device according to any of claims 2 to 4, wherein the bendable antiferromagnetic alloy memory element (1) further comprises

   • a substrate of a flexible metallic material (1c),
   • a capping electrical insulating layer (1b) located onto the substrate,
   • and wherein the layer of the crystalline metallic magnetic alloy (1a) is located onto the capping electrical insulating layer.

6. The antiferromagnetic recording device according to any of claims 2 to 5, wherein the bendable antiferromagnetic alloy memory element (1) further comprises a protective layer (1d) located onto the layer of the crystalline metallic alloy (1a).

7. The antiferromagnetic recording device according to claim 6, wherein the protective layer (1d) has a thickness of between 10 nm and 20 nm.

8. The antiferromagnetic recording device according to any of claims 2 to 7, wherein the bendable antiferromagnetic alloy memory element (1) comprises

- a substrate (1c) of a flexible Nickel-Molybdenum-Chromium alloy
- a capping electrical insulating layer (1b) of a columnar MgO carpet;
- a layer of a crystalline metallic alloy (1a) of $\alpha$-FeRh; and
- a Pt protecting layer (1d).

9. The antiferromagnetic recording device according to any of claims 1 to 8, wherein the writing element (2) is configured to create a magnetic field for setting the magnetization direction of the bendable magnetic memory element to its antiferromagnetic parallel and antiferromagnetic perpendicular states by means of a permanent magnetic element or an electromagnet.

10. The antiferromagnetic recording device according to any of claims 1 to 8, wherein the writing element (2) is configured to create a magnetic torque for setting the magnetization direction of the bendable magnetic memory element to its second ferromagnetic state by means of an electric current.

11. The antiferromagnetic recording device according to any of claims 1 to 10, wherein the electrical reading element (4) comprises at least two electrical contacts.

12. The antiferromagnetic recording device according to claim 11, wherein the electrical reading element (4) comprises between 2 and 6 electrical contacts.

Figure 1.

## Figure 2

Figure 3

Figure 4

Figure 5

Figure 6

Figure 7

Figure 8

**Figure 9**

a

b

**Figure 9 Cont.**

c

d

Europäisches
Patentamt

European
Patent Office

Office européen
des brevets

**EUROPEAN SEARCH REPORT**

Application Number

EP 19 38 3048

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 2 882 004 A1 (HITACHI LTD [JP]) 10 June 2015 (2015-06-10) * paragraph [0053]; figure 3 * * paragraph [0056] - paragraph [0066]; figures 6, 7 * | 1-12 | INV. G11C11/16 G11B5/65 H01F10/00 |
| Y | CN 109 507 616 A (NINGBO INST MATERIALS TECH & ENG CAS) 22 March 2019 (2019-03-22) * figures 1, 2 * | 1-12 | |
| A | EP 3 001 470 A1 (HITACHI LTD [JP]) 30 March 2016 (2016-03-30) * paragraph [0078] - paragraph [0080] * * paragraph [0080] - paragraph [0090]; figure 12 * | 1-12 | |

TECHNICAL FIELDS
SEARCHED (IPC)

G11C
G11B
H01F

The present search report has been drawn up for all claims

| Place of search | Date of completion of the search | Examiner |
|---|---|---|
| The Hague | 17 April 2020 | Knack, Steffen |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

 

& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 19 38 3048

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2020

| Patent document cited in search report | | Publication date | Patent family member(s) | | Publication date |
|---|---|---|---|---|---|
| EP 2882004 | A1 | 10-06-2015 | EP<br>JP | 2882004 A1<br>2015115603 A | 10-06-2015<br>22-06-2015 |
| CN 109507616 | A | 22-03-2019 | NONE | | |
| EP 3001470 | A1 | 30-03-2016 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D.H. KIM et al.** *Adv. Mater.,* 2008, vol. 20, 4887
- **S. WAGNER et al.** *MRS Bull.,* 2012, vol. 37, 207
- **I. MÖNCH et al.** *ACS Nano,* 2011, vol. 5, 7436
- **M. MELZER et al.** *RSC Adv.,* 2012, vol. 2, 2284
- **T. VEMULKAR et al.** *Adv. Funct. Mater.,* 2016, vol. 26, 4704
- **M. DONOLATO et al.** *Adv. Mater.,* 2013, vol. 25, 623
- **M. MELZER et al.** *Adv. Mater.,* 2015, vol. 27, 1274
- **M. MELZER et al.** *Nat. Commun.,* 2015, vol. 6, 6080
- **Z. WANG et al.** *Adv. Mater.,* 2016, vol. 28, 9370
- **J.-Y. CHEN et al.** *Sci. Rep.,* 2017, vol. 7, 42001
- **J. LIU ; Y. FENG ; R. TANG ; R. ZHAO ; J. GAO ; D. SHI ; H. YANG.** *Adv. Electron. Mater.,* 2018, vol. 4, 1700522
- **V. BALTZ ; A. MANCHON ; M. TSOI ; T. MORIYAMA ; T. ONO ; Y. TSERKOVNYAK.** *Rev. Mod. Phys.,* 2018, vol. 90, 015005